# EUROPEAN PATENT APPLICATION

(11) **EP 1 777 738 A1**
(43) Date of publication of application: **25.04.2007**
(21) Application number: 05745698.0
(22) Date of filing: 03.06.2005
(51) Int. Cl.: H01L 21/60, H05K 3/34, H05K 13/04

(54) **COMPONENT MOUNTING METHOD AND COMPONENT MOUNTING APPARATUS**

(30) Priority: 08.06.2004 JP 2004170288
(71) Applicant: MATSUSHITA ELECTRIC INDUSTRIAL CO., LTD., Kadoma-shi, Osaka 571-8501 (JP)
(72) Inventor: UENO, Yasuharu c/o Mat.Elec.Ind.Co.,Ltd.,IPROC,, Chuo-ku, Osaka-shi, Osaka 540-6319 (JP); MORIKAWA, Makoto c/o Mat.Ele.Ind.Co., Ltd., IPROC,, Chuo-ku, Osaka-shi, Osaka 540-6319 (JP); HIRATA, Shuichi c/o Mat.Elec.Ind.Co., Ltd., IPROC,, Chuo-ku, Osaka-shi, Osaka 540-6319 (JP); KOBAYASHI, Hironori c/o Mat.Ele.Ind.Co., Ltd.,, Chuo-ku, Osaka-shi, Osaka 540-6319 (JP); SHIDA, Satoshi c/o Mat.Ele.Ind.Co., Ltd., IPROC,, Chuo-ku, Osaka-shi, Osaka 540-6319 (JP)
(74) Representative: Haley, Stephen
(86) International application number: PCT/JP2005/010218
(87) International publication number: WO 2005/122237

(57) **Abstract**

A method and an apparatus for mounting electronic components that enables precise mounting of electronic components, such as deformation-prone thin IC chips or fine-pitch and high-pin-count IC chips, on a substrate. Thin IC chips, which conventionally tend to lose flatness because of warping that occurs during production or deformation that occurs when picked up with a suction nozzle, are pressed against a substrate (4) with a preset load using a suction nozzle with a flat suction surface (11b) so as to correct deformation; the suction nozzle (11) is controlled to move up to make up for a decrease in the distance between the oppositely spaced IC chip and the substrate (4) that is caused by thermal expansion due to the heating for melting solder bumps (1a) on the electrodes; and the suction nozzle (11) is controlled to move down to mitigate the effect of a pulling-apart force applied to the molten parts as the thermally expanded parts cool down and contract.

## Description

### TECHNICAL FIELD

The present invention relates to a method and an apparatus for mounting electronic components on a substrate which is a target object using flip-chip mounting techniques, and in particular to a component mounting method and a component mounting apparatus which enable precise mounting of electronic components such as thin IC chips and fine-pitch and high-pin-count IC chips on the substrate.

### BACKGROUND ART

One of the technologies that support the great progress in size and weight reductions and sophistication of portable information equipment such as notebook PCs and mobile phones is the high-density mounting technique. With the progress of high-density integration technology, the number of IC chip electrodes that will serve as external connection terminals has increased, and these electrodes are finely pitched; the high-density mounting techniques are essential for mounting such IC chips on the electrodes of the substrate without short-circuiting or connection failure. The flip-chip mounting techniques are a typical high-density mounting method, and solder bonding, in particular, is commonly used for the bonding of IC chips.

There have been known techniques for mounting IC chips with finely-pitched electrodes on the substrate, which use a method and an apparatus for mounting electronic components with the solder bonding method (see Patent Document 1).

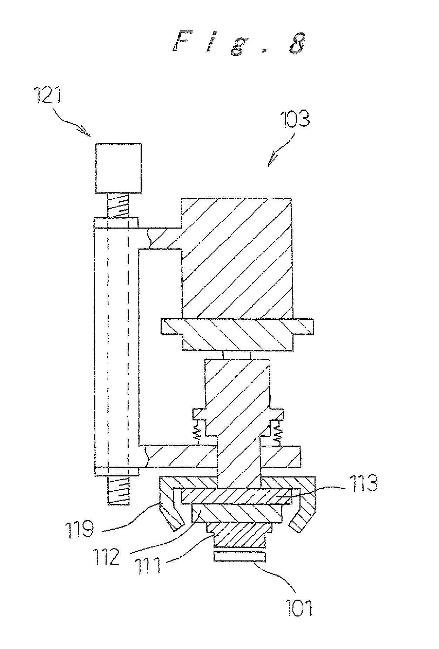

The conventional component mounting apparatus mentioned above is shown in Fig. 8. The IC chip 101 is held with a suction nozzle 111 at the tip of a placement head 103 that is moved up and down with an up/down drive means 121; the placement head 103 is lowered to place the IC chip 101 on the substrate; the IC chip 101 is heated with a ceramic heater 112 provided at the back of the suction nozzle 111; protruded electrodes or solder bumps on the IC chip 101 are fused with electrodes on the substrate, after which the bonded protruded electrodes are solidified by blowing cooling air from a blow nozzle 119; and suction from the suction nozzle 111 is released and the placement head 103 is moved up, so that the IC chip is mounted on the substrate. Reference numeral 113 denotes a water jacket for insulating heat from the ceramic heater 112 so that it is not conducted to the apparatus main body.

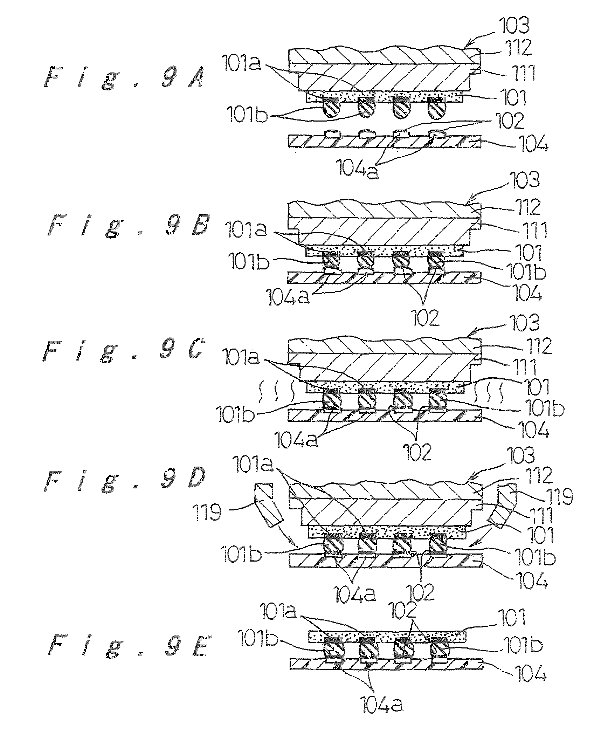

Fig. 9A to Fig. 9E successively illustrate the process steps of mounting the IC chip 101 on the substrate 104 using the above-described component mounting apparatus. As shown in Fig. 9A, the IC chip 101 is held with the suction nozzle 111, the IC chip having solder bumps 101b respectively provided to a plurality of electrodes 101a. The placement head 103 is moved to above the substrate 104 and positioned so that the IC chip 101 is above a preset position on the substrate 104. Next, as shown in Fig. 9B, the placement head 103 is moved down so that each of the solder bumps 101b on the IC chip 101 makes contact with additional solder 102 that has been supplied on the pads (substrate electrodes) 104a on the substrate 104. Next, as shown in Fig. 9C, the IC chip 101 is heated through the suction nozzle 111 using the ceramic heater 13.2 to a temperature that is higher than the melting point of solder, i.e., the solder bumps 101b and additional solder 102, so that the solder bumps 101b and additional solder 102 melt. Next, as shown in Fig. 9D, the heating with the ceramic heater 112 is stopped, and cooling air is blown out from the blow nozzle 119 toward the molten solder to forcibly cool down and solidify the solder, so that the electrodes 101a of the IC chip 101 are bonded to the pads 104a on the substrate 104. After that, suction applied to the IC chip 101 from the suction nozzle 111 is released, and the placement head 103 is moved up, whereby the IC chip 101 is mounted on the substrate 104 as shown in Fig. 9E.

The above mounting method solves a problem in the conventional bonding methods that use solder bumps, in which suction applied to the IC chip 101 from the suction nozzle 111 is released during the melting process of solder, so that the electrodes on the chip are self-aligned to be in the matching bonding positions with the electrodes on the substrate using the surface tension of molten solder. The problem was that this method could not deal with fine-pitch chips that require high positional precision and cannot tolerate the slight misalignment in the bonding positions that may occur when air is blown to break vacuum to release the chip. Since the bonding positions of the chip electrodes and of the substrate electrodes are matched by moving the placement head 103 and suction is released not during the solder melts but after it has solidified, no misalignment occurs in the bonding positions when air is blown to break vacuum, and therefore, fine-pitch IC chip 101 can be mounted in a stable manner without the risk of possible bonding failures such as short-circuiting across the fine-pitch electrodes or connection failure.

Patent Document 1: Japanese Patent Publication No. 2003-008196

### PROBLEMS TO BE SOLVED BY THE INVENTION

IC chips, however, tend to be made thinner and thinner and are prone to warping after they are diced from wafers and processed into IC chips, and it can readily happen that IC chips lose flatness. Also when a thin IC chip is held with a suction nozzle, the vacuum is concentrated in the central portion of the IC chip, and warping can readily occur because the central portion is pulled up.

The problem with the above-described conventional mounting method was that when thin IC chips, which are prone to undulation due to the warping that occurred during the production and are prone to warping when suction is applied, are to be mounted on a substrate, the plurality of protruded electrodes on the IC chip made contact with the plurality of electrodes on the substrate in different conditions, because of which precise bonding between the protruded electrodes and substrate electrodes was not possible.

Heat from the heater conducts to the suction nozzle and to the placement head in which the heater is set and causes thermal expansion, which changes the contact pressure of the protruded electrodes to the substrate electrodes, and therefore the placement head is controlled to move up as it heats up so as to correct changes caused by thermal expansion. However, the heat from the heater also conducts through the suction nozzle and the IC chip to the stage that holds the substrate and causes thermal expansion in the stage, but not much consideration was given to this issue. Moreover, thermal expansion occurs in the stage with a time lag after the thermal expansion occurs in the placement head, but no control scheme was adopted to deal with this.

Similarly, when heating is stopped and cooling is started, contraction occurs in the placement head, and so the placement head is controlled to move down to make up for it, but no consideration was given to contraction in the mounting stage.

After the downward movement to make up for the contraction during cooling, when thermal expansion occurs in the placement head because of heat conducted from the stage which is cooling down with a time lag, the molten parts that are solidifying are subjected to a force in a pulling-apart direction, which sometimes result in an open failure due to interface or crack formation in the joint, the problem being that this leads to an increase in electrical resistance or possible bonding failure such as connection failure.

An object of the invention is, to solve the above problems, to provide a method and an apparatus for mounting components that enables precise mounting of electronic components such as thin IC chips that tend to lose flatness and fine-pitch and high-pin-count IC chips on the substrate.

### MEANS FOR SOLVING THE PROBLEMS

To achieve the above object, a first aspect of the present invention is a component mounting method comprising the steps of: holding an electronic component formed with a plurality of protruded electrodes with a suction nozzle set in a placement head that is controlled to move up and down, while a substrate formed with a plurality of substrate electrodes is held on a mounting stage; lowering the placement head so that the protruded electrodes make contact with the substrate electrodes; and applying heat to melt the protruded electrodes to bond both electrodes together to mount the electronic component on the substrate, wherein the method including the steps of: detecting contact load when the placement head is lowered and the protruded electrodes make contact with the substrate electrodes; lowering the suction nozzle to a position where a preset contact load is detected, after which heat is applied to melt and fuse the protruded electrodes with the substrate electrodes; stopping heating to cool down and solidify the molten parts; and releasing suction from the suction nozzle and moving up the placement head.

With this first component mounting method, the placement head is lowered to press the electronic component onto the substrate until a preset contact load is detected, and so even if the electronic component has lost its flatness because of undulation or warping due to the suction, it is corrected to have a desired flatness as it is pressed with a flat suction surface of the suction nozzle, and therefore bonding failures that may result from deformation of IC chips are prevented. IC chips, which are one example of electronic components, tend to be made thinner, and they include a multiplicity of fine-pitch electrodes due to high integration technologies; if they are not completely flat, all the electrodes may not be uniformly bonded to the substrate electrodes. With this component mounting method, even electronic components that are thin and can easily lose their flatness are mounted with good bonding conditions.

A second aspect of the present invention is a component mounting method comprising the steps of: holding an electronic component formed with a plurality of protruded electrodes with a suction nozzle set in a placement head that is controlled to move up and down, while a substrate formed with a plurality of substrate electrodes is held on a mounting stage; lowering the placement head so that the protruded electrodes make contact with the substrate electrodes; and applying heat to melt the protruded electrodes to bond both electrodes together to mount the electronic component on the substrate, wherein the method including the steps of: lowering the placement head so that the protruded electrodes make contact with the substrate electrodes; moving up the placement head by an amount that makes up for thermal expansion that occurs in the placement head and in the mounting stage when they heat up and whose amount is known beforehand; applying heat to a preset temperature to melt and fuse the protruded electrodes with the substrate electrodes; stopping heating to cool down and solidify the molten parts; and releasing suction applied to the electronic component from the suction nozzle and moving up the placement head.

With this second component mounting method, the placement head in its lowered position is moved down because of thermal expansion in the placement head and in the mounting stage as they are heated, but this is corrected by controlling the placement head to move up. Therefore it is prevented that an excessive load is applied to molten protruded electrodes to cause the molten parts to bulge sideways, which may lead to short-circuiting across adjacent electrodes. Short-circuiting resulting from bulged molten parts can readily occur particularly in fine-pitch and high-pin-count IC chips, but such short-circuiting resulting from bulged molten parts is prevented by controlling the placement head to move up.

A third aspect of the present invention is a component mounting method comprising the steps of: holding an electronic component formed with a plurality of protruded electrodes with a suction nozzle set in a placement head that is controlled to move up and down, while a substrate formed with a plurality of substrate electrodes is held on a mounting stage; lowering the placement head so that the protruded electrodes make contact with the substrate electrodes; and applying heat to melt the protruded electrodes to bond both electrodes together to mount the electronic component on the substrate, wherein the method including the steps of: lowering the placement head so that the protruded electrodes make contact with the substrate electrodes; applying heat to a preset temperature to melt and fuse the protruded electrodes with the substrate electrodes; stopping heating and moving down the placement head by an amount that makes up for contraction that occurs in the placement head and in the mounting stage when they cool down; and after the molten parts have solidified, releasing suction applied to the electronic component from the suction nozzle and moving up the placement head.

With this third component mounting method, after the protruded electrodes have melted and fused with the substrate electrodes, the heating is stopped and cooling started, and in response to the contraction that occurs in the placement head and the mounting stage that have thermally expanded, the placement head is controlled to move down. Therefore the pulling-apart force is not applied to the joint surfaces when contraction occurs, and it is prevented that an interface or open failure is created in the joint surfaces because of the pulling-apart force, which will lead to an increase in the joint resistance and bonding failure.

A fourth aspect of the present invention is a component mounting method comprising the steps of: holding an electronic component formed with a plurality of protruded electrodes with a suction nozzle set in a placement head that is controlled to move up and down, while a substrate formed with a plurality of substrate electrodes is held on a mounting stage; lowering the placement head so that the protruded electrodes make contact with the substrate electrodes; and applying heat to melt the protruded electrodes to bond both electrodes together to mount the electronic component on the substrate, wherein the method including the steps of: detecting contact load when the placement head is lowered and the protruded electrodes make contact with the substrate electrodes; lowering the suction nozzle to a position where a preset contact load is detected; moving up the placement head by an amount that makes up for thermal expansion that occurs in the placement head and in the mounting stage when they heat up and whose amount is known beforehand; applying heat to a preset temperature to melt and fuse the protruded electrodes with the substrate electrodes; stopping heating to cool down and solidify the molten parts; and after the molten parts have solidified, releasing suction applied to the electronic component from the suction nozzle and the placement head is moved up.

With this fourth component mounting method, the placement head is controlled to move down to press the electronic component onto the substrate until a preset contact load is detected, and so even if the electronic component has lost its flatness because of undulation or warping due to the suction, it is corrected to have a desired flatness as it is pressed with a flat suction surface of the suction nozzle, and therefore bonding failures that may result from deformation of IC chips are prevented. Also, the placement head is controlled to move up to compensate for a downward displacement of the lowered placement head that is caused by thermal expansion in the placement head and in the mounting stage as they heat up. Therefore it is prevented that an excessive load is applied to molten protruded electrodes to cause the molten parts to bulge sideways, which may lead to short-circuiting across adjacent electrodes.

A fifth aspect of the present invention is a component mounting method comprising the steps of: holding an electronic component formed with a plurality of protruded electrodes with a suction nozzle set in a placement head that is controlled to move up and down, while a substrate formed with a plurality of substrate electrodes is held on a mounting stage; lowering the placement head so that the protruded electrodes make contact with the substrate electrodes; and applying heat to melt the protruded electrodes to bond both electrodes together to mount the electronic component on the substrate, wherein the method including the steps of: detecting contact load when the placement head is lowered and the protruded electrodes make contact with the substrate electrodes; lowering the suction nozzle to a position where a preset contact load is detected; applying heat to a preset temperature to melt and fuse the protruded electrodes with the substrate electrodes; stopping heating and moving down the placement head by an amount that makes up for contraction that occurs in the placement head and in the mounting stage when they cool down; and after the molten parts have solidified, releasing suction applied to the electronic component from the suction nozzle and moving up the placement head.

With this fifth component mounting method, the placement head is controlled to move down to press the electronic component onto the substrate until a preset contact load is detected, and so even if the electronic component has lost its flatness because of undulation or warping due to the suction, it is corrected to have a desired flatness as it is pressed with a flat suction surface of the suction nozzle, and therefore bonding failures that may result from deformation of IC chips are prevented. Also, after the protruded electrodes have melted and fused with the substrate electrodes, the heating is stopped and cooling started, and in response to the contraction that occurs in the placement head and the mounting stage that have thermally expanded, the placement head is controlled to move down. Therefore the pulling-apart force is not applied to the joint surfaces when contraction occurs, and it is prevented that an interface or open failure is created in the joint surfaces because of the pulling-apart force, which will lead to an increase in the joint resistance and bonding failure.

A sixth aspect of the present invention is a component mounting method comprising the steps of: holding an electronic component formed with a plurality of protruded electrodes with a suction nozzle set in a placement head that is controlled to move up and down, while a substrate formed with a plurality of substrate electrodes is held on a mounting stage; lowering the placement head so that the protruded electrodes make contact with the substrate electrodes; and applying heat to melt the protruded electrodes to bond both electrodes together to mount the electronic component on the substrate, wherein the method including the steps of: detecting contact load when the placement head is lowered and the protruded electrodes make contact with the substrate electrodes; lowering the suction nozzle to a position where a preset contact load is detected; moving up the placement head by an amount that makes up for thermal expansion that occurs in the placement head and in the mounting stage when they heat up and whose amount is known beforehand; applying heat to a preset temperature to melt and fuse the protruded electrodes with the substrate electrodes; stopping heating and moving down the placement head is moved down by an amount that makes up for contraction that occurs in the placement head and in the mounting stage when they cool down; and after the molten parts have solidified, releasing suction applied to the electronic component from the suction nozzle and moving up the placement head.

With this sixth component mounting method, the placement head is controlled to move down to press the electronic component onto the substrate until a preset contact load is detected, and so even if the electronic component has lost its flatness because of undulation or warping due to the suction, it is corrected to have a desired flatness as it is pressed with a flat suction surface of the suction nozzle, and therefore bonding failures that may result from deformation of IC chips are prevented. Also, the placement head is controlled to move up to compensate for a downward displacement of the lowered placement head that is caused by thermal expansion in the placement head and in the mounting stage as they heat up. Therefore it is prevented that an excessive load is applied to molten protruded electrodes to cause the molten parts to bulge sideways, which may lead to short-circuiting across adjacent electrodes. Furthermore, after the protruded electrodes have melted and fused with the substrate electrodes, the heating is stopped and cooling started, and in response to the contraction that occurs in the placement head and the mounting stage that have thermally expanded, the placement head is moved down. Therefore the pulling-apart force is not applied to the joint surfaces when contraction occurs, and it is prevented that an interface or open failure is created in the joint surfaces because of the pulling-apart force, which will lead to an increase in the joint resistance and bonding failure.

In any of the above first to sixth component mounting methods, a temperature that is lower than the solidifying point of solder is maintained for a preset period of time, and only after the molten parts have solidified, the suction applied to the electronic component from the suction nozzle is released. That is, suction is released and the electronic component is separated from the suction nozzle after the molten parts between the protruded electrodes and substrate electrodes have completely solidified and both electrodes have been correctly bonded together, and therefore vibration that occurs when the component is separated will not cause any failure in the joints.

In the preset time period in which the temperature that is lower than the solidifying point of solder is maintained so as to solidify the molten parts, the direction in which load is applied to the electronic component is detected to control the placement head to move up or down depending on the detected load direction. This prevents possible short-circuiting which may result from bulged molten parts that are in the process of solidifying but compressed because the distance between the opposite electronic component and substrate is reduced due to thermal expansion that occurs in the suction nozzle again because of heat conducted from the mounting stage that supports the substrate, or prevent a pulling-apart force to be applied to molten parts that are in the process of solidifying because the distance between the opposite electronic component and substrate is increased due to resiliency of the electronic component.

After the preset time period in which the temperature that is lower than the solidifying point of solder is maintained so as to solidify the molten parts, suction applied to the electronic component from the suction nozzle is released when a preset load is detected that determines whether the solder has solidified. When the distance between the opposite electronic component and substrate is reduced due to thermal expansion that occurs in the suction nozzle again because of heat conducted from the mounting stage that supports the substrate, if the molten parts have already solidified, a load indicative of that fact is detected, and so if this is detected, the electronic component is released from the suction nozzle assuming that solidification has completed, and thereby a time reduction is achieved.

One embodiment of the component mounting apparatus of the present invention, wherein an electronic component formed with a plurality of protruded electrodes is held with a suction nozzle set in a placement head, while a substrate formed with a plurality of substrate electrodes is held on a mounting stage; the placement head is controlled to move up and down and lowered so that the protruded electrodes make contact with the substrate electrodes; and heat is applied to melt the protruded electrodes to bond both electrodes together to mount the electronic component on the substrate, wherein the apparatus comprising means for detecting contact load when the placement head is lowered and the protruded electrodes make contact with the substrate electrodes, and a control unit for controlling the up and down movement of the placement head so that the contact load detected by this contact load detecting means reaches a preset level.

With this component mounting apparatus, the control unit executes control to lower the placement head to press the electronic component onto the substrate until a preset contact load is detected, and so even if the electronic component has lost its flatness because of undulation or warping due to the suction, it is corrected to have a desired flatness as it is pressed with a flat suction surface of the suction nozzle, and therefore bonding failures that may result from deformation of IC chips are prevented. IC chips, which are one example of electronic components, tend to be made thinner, and they include a multiplicity of fine-pitch electrodes due to high integration technologies; if they are not completely flat, all the electrodes may not be uniformly bonded to the substrate electrodes. With the above-described control, even electronic components that are thin and can easily lose their flatness are mounted with good bonding conditions.

Another embodiment of the component mounting apparatus of the present invention, wherein an electronic component formed with a plurality of protruded electrodes is held with a suction nozzle set in a placement head, while a substrate formed with a plurality of substrate electrodes is held on a mounting stage; the placement head is controlled to move up and down and lowered so that the protruded electrodes make contact with the substrate electrodes; and heat is applied to melt the protruded electrodes to bond both electrodes together to mount the electronic component on the substrate, wherein the apparatus comprising a control unit for controlling the placement head in its lowered position to move up by an amount in accordance with thermal expansion that occurs in the placement head and in the mounting stage when they heat up, and for controlling the placement head to move down by an amount that makes up for contraction that occurs in the placement head and in the mounting stage when they cool down after heating is stopped.

With this component mounting apparatus, the placement head in its lowered position is moved down because of thermal expansion in the placement head and in the mounting stage as they heat up, but this is corrected by controlling the placement head to move up. Therefore it is prevented that an excessive load is applied to molten protruded electrodes to cause the molten parts to bulge sideways, which may lead to short-circuiting across adjacent electrodes. Short-circuiting resulting from bulged molten parts can readily occur particularly in fine-pitch and high-pin-count IC chips, but such short-circuiting resulting from bulged molten parts is prevented by controlling the placement head to move up. Further, after the protruded electrodes have melted and fused with the substrate electrodes, the heating is stopped and cooling started, and in response to the contraction that occurs in the placement head and the mounting stage that have thermally expanded, the placement head is controlled to move down. Therefore the pulling-apart force is not applied to the joint surfaces when contraction occurs, and it is prevented that an interface or open failure is created in the joint surfaces because of the pulling-apart force, which will lead to an increase in the joint resistance and bonding failure.

Yet another embodiment of the component mounting apparatus of the present invention, wherein an electronic component formed with a plurality of protruded electrodes is held with a suction nozzle set in a placement head, while a substrate formed with a plurality of substrate electrodes is held on a mounting stage; the placement head is controlled to move up and down and lowered so that the protruded electrodes make contact with the substrate electrodes; and heat is applied to melt the protruded electrodes to bond both electrodes together to mount the electronic component on the substrate, wherein the apparatus comprising means for detecting contact load when the placement head is lowered and the protruded electrodes make contact with the substrate electrodes, and a control unit for controlling the up and down movement of the placement head so that the contact load detected by this contact load detecting means reaches a preset level, for controlling the placement head in its lowered position to move up by an amount in accordance with thermal expansion that occurs in the placement head and in the mounting stage when they heat up, and for controlling the placement head to move down by an amount that makes up for contraction that occurs in the placement head and in the mounting stage when they cool down after heating is stopped.

With this component mounting apparatus, the control unit executes control to lower the placement head to press the electronic component onto the substrate until a preset contact load is detected, and so even if the electronic component has lost its flatness because of undulation or warping due to the suction, it is corrected to have a desired flatness as it is pressed with a flat suction surface of the suction nozzle, and therefore bonding failures that may result from deformation of IC chips are prevented. Further, the placement head in its lowered position is moved down because of thermal expansion in the placement head and in the mounting stage as they heat up, but this is corrected by controlling the placement head to move up. Therefore it is prevented that an excessive load is applied to molten protruded electrodes to cause the molten parts to bulge sideways, which may lead to short-circuiting across adjacent electrodes. Moreover, after the protruded electrodes have melted and fused with the substrate electrodes, the heating is stopped and cooling started, and in response to the contraction that occurs in the placement head and the mounting stage that have thermally expanded, the placement head is moved down. Therefore the pulling-apart force is not applied to the joint surfaces when contraction occurs, and it is prevented that an interface or open failure is created in the joint surfaces because of the pulling-apart force, which will lead to an increase in the joint resistance and bonding failure.

In any of the above apparatuses, it is preferable to provide a heat insulating member having a thermal expansion coefficient of not more than 1 x 10⁻⁶ between the placement head main body and heating means that is interposed between the suction nozzle and the placement head main body. This suppresses heat conduction from the heating means to the placement head body, and mitigates effects of thermal expansion.

The suction surface of the suction nozzle on which the electronic component is held may include suction grooves that communicate with suction holes and are arrayed with a preset density over a region corresponding to the area of the electronic component. Thereby, the electronic component is sucked with the suction holes as well as the suction grooves, i.e., uniformly and entirely, without the suction force being concentrated locally. Local concentration of suction force on thin electronic components may lead to deformation, but by applying suction uniformly and entirely, electronic components that are easily deformable are held without the risk of deformation.

### BRIEF DESCRIPTION OF THE DRAWINGS

Fig. 1 is a cross-sectional view illustrating the main features of one embodiment of the mounting apparatus.
Fig. 2A to Fig. 2E are schematic views successively illustrating the process steps of mounting an IC chip on the substrate using the apparatus of Fig. 1.
Fig. 3 is a flowchart of the control steps of the mounting operation of the apparatus of Fig. 1
Fig. 4 is a timing chart in the control steps of Fig. 3, illustrating the timing at which various motions occur.
Fig. 5 is a flowchart of a variation of the control steps.
Fig. 6 is a flowchart of another variation of the control steps.
Fig. 7 is a plan view of one example of a suction nozzle in this embodiment.
Fig. 8 is a cross-sectional view illustrating the main features of a conventional component mounting apparatus.
Fig. 9A to Fig. 9E are schematic views successively illustrating the conventional mounting process steps.

### BEST MODE FOR CARRYING OUT THE INVENTION

The following embodiment of the invention is a component mounting method and a component mounting apparatus for mounting IC chips on a substrate, the IC chips being one example of electronic components and having solder bumps as protruded electrodes, which are fused to pads on the substrate (substrate electrodes). More particularly, a method and apparatus for controlling the mounting operations is provided, which enables precise mounting of thin IC chips that tend to lose their flatness, or fine-pitch and high-pin-count IC chips. Target object on which IC chips are mounted is a substrate here, but it may not necessarily be a circuit substrate but an IC chip, e.g., in the case with "chip-on-chip", in which an IC chip is mounted on another IC chip.

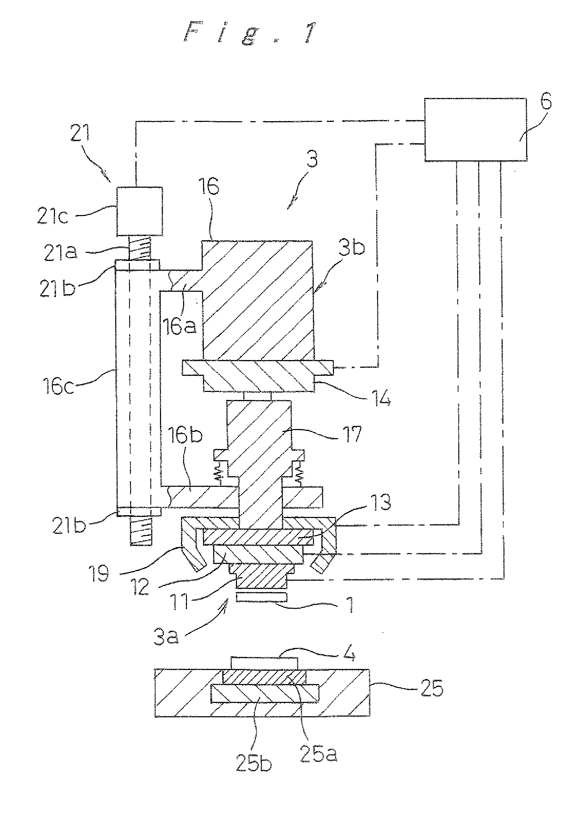

Fig. 1 illustrates the main features of one embodiment of the mounting apparatus; the drawing shows the part of a placement head 3 where an IC chip 1 is held with a suction nozzle 11 to be mounted on a substrate 4 held on a mounting stage 25. The placement head 3 is designed to be freely movable from a component supply position to a component placement position by the use of an X-Y robot (not shown), and to move up and down with an up/down drive unit 21.

At the tip of the mounting head 3 is attached a mounting tool 3a, which includes the suction nozzle 11 having a shape and size that matches with the IC chip 1 to be picked up, a ceramic heater 12 for heating the IC chip 1 held on the suction nozzle 11, an insulator 13 for providing thermal insulation so that heat from the ceramic heater 12 does not conduct to the placement head body 3b, a blow nozzle 19 for blowing cooling air to the heated IC chip 1, and a support shaft 17 for supporting all these components.

The placement head body 3b includes a frame 16 that supports the mounting tool 3a in a suspended manner, and a load cell 14 for detecting contact load between the substrate 4 and the IC chip 1 held on the suction nozzle 11. The frame 16 consists of an upper frame 16a, a lower frame 16b that guides the up and down movement of the support shaft 17, and an intermediate frame 16c that connects the upper frame and lower frame; nuts 21b are provided to the upper and lower ends of the intermediate frame, and a ball screw shaft 21a that meshes with the nuts is fitted in the intermediate frame to form the up/down drive unit 21. The ball screw shaft 21a is driven to rotate with the up/down drive motor 21c to move the placement head 3 up and down. This up/down drive structure using the ball screw facilitates control of up and down movement of the placement head 3 by a very small amount. The center axis of the mounting tool 3a is parallel with the axis along which it is moved up and down with the up/down drive unit 21; thus the mounting tool 3a can be controlled to freely move up and down with the up/down drive unit 21.

The load cell 14 is one type of load measuring device that uses a strain gauge. When the placement head 3 lowers and the solder bumps 1a on the IC chip 1 held on the suction nozzle 11 at the tip of the placement head make contact with the substrate electrodes 4a on the substrate 4, the top end of the support shaft 17 that is part of the mounting tool 3a pushes up the load sensing surface of the load cell 14, whereby the load is detected as a strain in a resilient member which is a component of the load cell 14, which is then converted to an electrical signal representing the strain and output as the detected load.

The placement head 3 with the above design is freely moved in a horizontal direction with an X-Y robot (not shown) to perform the mounting operations; it is moved to a component supply position and lowered to pick up an IC chip supplied there with the suction nozzle 11, and then moved horizontally to a component mounting position to mount the IC chip 1 on the substrate 4 that has been supplied on the mounting stage 25 at the component mounting position. On the mounting stage 25 are provided a substrate holding nozzle 25a for holding the substrate 4 by suction, and a heater 25b for pre-heating the substrate 4.

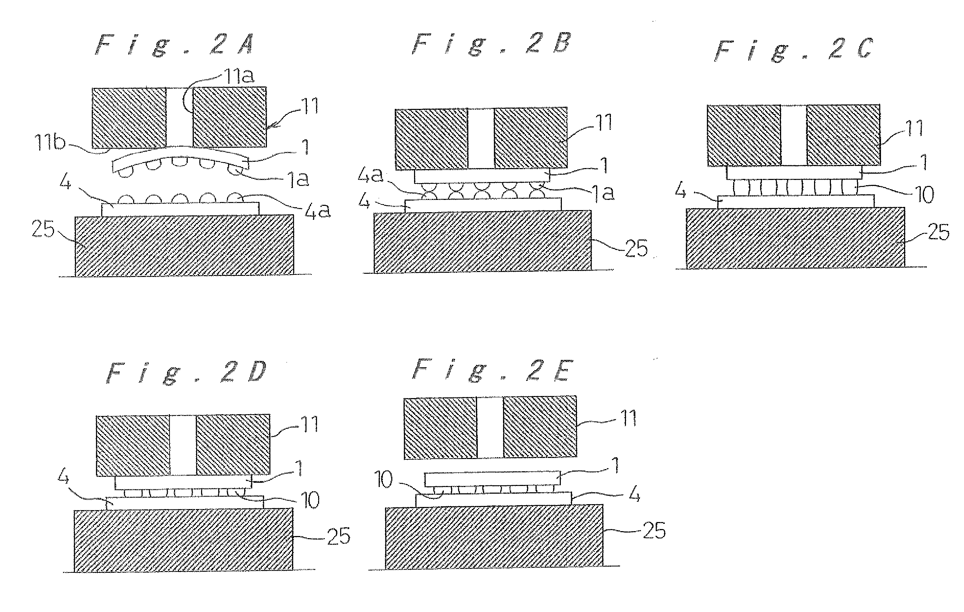

The method of controlling the mounting operation for mounting the IC chip 1 on the substrate 4 using the above-described placement head 3 will be described with reference to Fig. 2A to Fig. 4. The following control operation is executed with a control unit 6 in the component mounting apparatus.

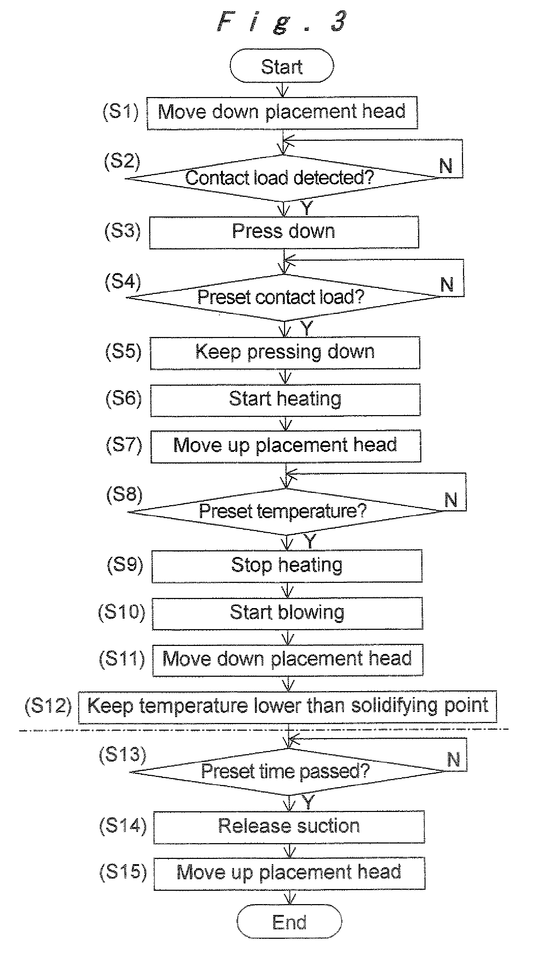

Fig. 3 is a flowchart showing the control steps taken by the control unit 6; the description of the control operation will be made in the order of the control steps. The reference numerals S1, S2, etc. in the drawing represent the number of control steps and correspond to the numbers given in this specification.

The placement head 3 that has been moved to the component supply position with the X-Y robot (not shown) and picked up the IC chip 1 with the suction nozzle 11 is moved to the component mounting position with the X-Y robot and positioned such that the IC chip 1 is located above the mounting position on the substrate 4 held on the mounting stage 25, at which point the up/down drive unit 21 starts the lowering movement (S1). When the IC chip 1 is a thin type, as mentioned above, when it is picked up by the suction nozzle 11, it can easily warp, with the central portion opposite the suction hole 11a being sucked by vacuum while the periphery is not, as shown in Fig. 2A. Thin IC chips 1 are anyway prone to warping or undulation during the production process. Therefore, as the placement head 3 is lowered, of the plurality of solder bumps (protruded electrodes) 1a on the mounting surface of the IC chip 1 held on the suction nozzle 11, one or more of the solder bumps 1a that are located lowermost because of the deformation of the IC chip 1 make contact with the substrate electrodes 4a on the substrate 4. The load cell 14 detects the contact load that acts when part of the solder bumps 1a contacts the substrate electrodes 4a (S2), and the detection result is input to the control unit 6, which causes the placement head 3 to continue moving down until a preset contact load is detected so that the IC chip 1 is pressed against on the substrate 4 (S3). When the preset contact load is input from the load cell 14 (S4), the placement head 3 stops the downward movement and holds the position where it presses down the IC chip 1 (S5). With this action of pressing down the IC chip 1, even if the IC chip 1 has been deformed, it is corrected to have desired flatness that conforms to the suction surface 11b of the suction nozzle 11, as shown in Fig. 2B.

While the placement head 3 is held at the height so that the IC chip 1 is kept in pressure contact with the substrate 4, the heating temperature of the ceramic heater 12 is raised (S6). The ceramic heater 12 is turned on after a preset time has passed after the suction nozzle 11 has picked up the IC chip 1, and pre-heats the IC chip 1 to a preset temperature that is not as high as the melting point of the solder bumps 1a. The substrate 4 on the mounting stage 25 is also preheated with the substrate heater 25b to a preset temperature that is not as high as the melting point of the solder that has been supplied on the surface of the substrate electrodes 4a.

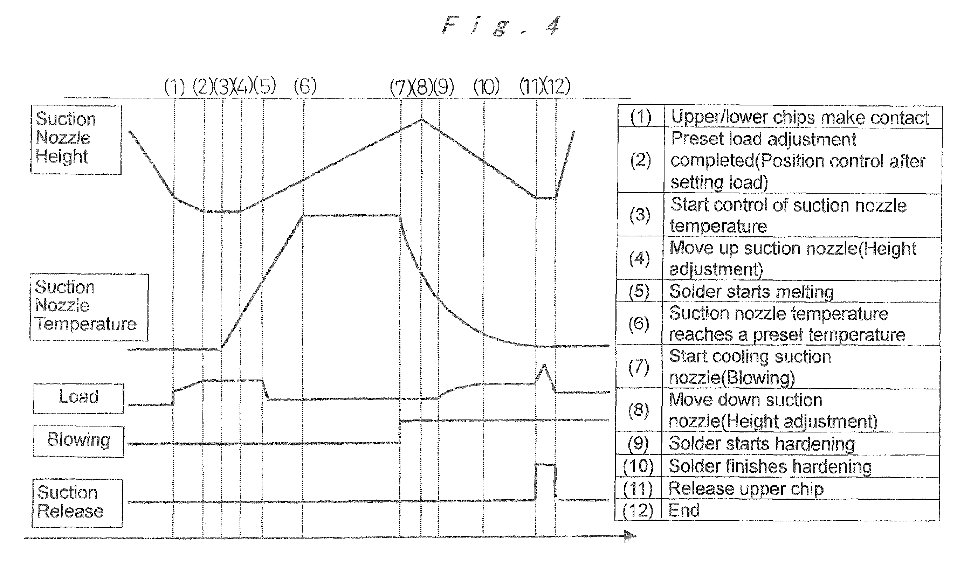

Fig. 4 illustrates changes in the height of the suction nozzle 11 moved with the placement head 3 and in the temperature of the suction nozzle 11 heated with the ceramic heater 12 at various timings denoted at (1) to (12). After sometime after the start of the heating of the suction nozzle 11 with the ceramic heater 12, a temperature rise in the suction nozzle 11 brings about thermal expansion in the nozzle and others, which causes a change in the height of the suction nozzle 11 on the placement head 3. Therefore the placement head 3 is moved up to make up for the thermal expansion, whose amount is known beforehand (S7). The upward movement of the placement head 3 is continued for a preset time after the heating has been stopped as shown in Fig. 4 because the temperature of the suction nozzle does not plummet after the heating with the ceramic heater 12 is stopped and the blowing of cooling air is started. The thermal expansion occurs not only on the side of the mounting tool 3a; it occurs also in the mounting stage 25 because of the heat conducted through the IC chip 1 and the substrate 4 to the mounting stage 25, and this lags behind the expansion on the side of the mounting tool 3a and can be preliminarily measured. Therefore, as shown in Fig. 4, the placement head 3 is moved up later than the start of the heating with the ceramic heater 12 and by an amount that is determined in consideration of the thermal expansion in the mounting stage 25.

When the heating temperature of the ceramic heater 12 reaches the melting point of the solder bumps 1a (S8), the solder bumps 1a and the solder on the substrate electrodes 4a melt and fuse together as shown in Fig. 2C. Therefore the heating is stopped (S9) and the blowing of cooling air is started (S10). The blowing is done with the blow nozzle 19 provided to the mounting tool 3a by blowing cool air toward the IC chip 1. The blowing need not involve the use of cooling air blown from the blow nozzle 19 and the IC chip may be let to cool down.

This cooling brings about contraction in the placement head 3 and the mounting stage 25 that have been thermally expanded, and the oppositely spaced IC chip 1 and the substrate 4 separate from each other. To correct this, the placement head 3, which has been moved up after a preset time after the stop of the heating and the start of the cooling air blow, is switched to move down (S11) as shown in Fig. 4, and controlled to move down to the height where the IC chip 1 is oppositely spaced from the substrate 4 as shown in Fig. 2D.

After the downward movement, the placement head 3 is maintained for a preset time at a temperature that is lower than the solidifying point of the joint 10 of the solder bump 1a and solder on the substrate electrode 4a (S12). A preset waiting time is provided (S13) , so that the joint 10 is formed in an appropriate shape, without an interface or an open failure being created in the joint because of the force that acts in a pulling-apart direction during the solidification of the solder, whereby an increase in electrical resistance or connection failure is prevented.

After the preset time has passed that ensures formation of a reliable joint, suction applied to the IC chip 1 from the suction nozzle 11 is released (S14), and the placement head 3 is moved up (S15), whereby the IC chip 1 is mounted on the substrate 4 as shown in Fig. 2E.

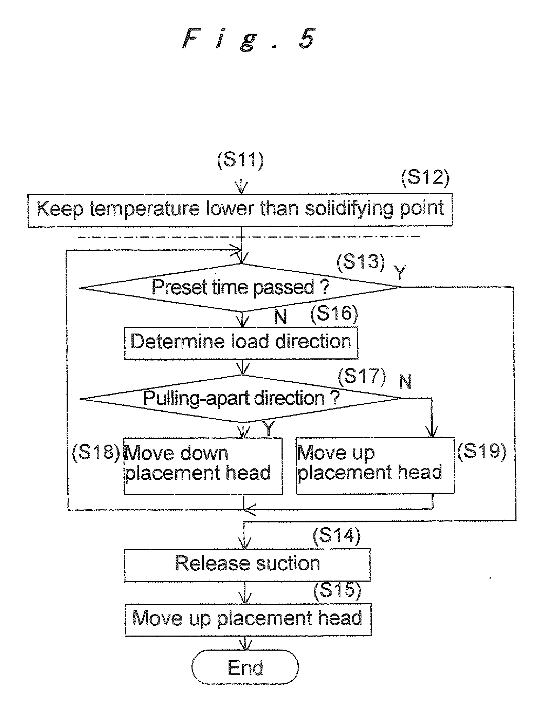

With the above-described mounting control method, the position in the up and down direction of the suction nozzle 11 is appropriately controlled during the process of solidification of molten solder, and this prevents creation of an interface or an open failure in the joint because of the force in a pulling-apart direction due to the contraction resulting from solidification of solder. Another control method that prevents the problem of this force in the pulling-apart direction even more reliably will be described below with reference to the flowchart of Fig. 5. Fig. 5 shows a variation of control steps of the flowchart of Fig. 3 after the step S12 onward. The control steps up until the step S12 are the same as the previously described control method, and therefore the description and illustration of these steps are omitted.

Referring to Fig. 5, in the step of waiting for a preset time to be passed while a temperature lower than the solidifying point of solder is maintained so as to let the molten solder to solidify (S13), the direction in which load is being applied is determined based on the load detected with the load cell 14 (S16). If the load direction is in the direction in which the joint surfaces are pulled apart, that is, if, with the placement head 3 being halted at its lowered position, a smaller load is detected because the placement head 3 and the mounting stage 25 that have been thermally expanded now contract as they cool down, then the placement head 3 is lowered (S18), assuming that the placement head 3 is not lowered enough to match the amount of contraction and the joint surfaces are subjected to a pulling-apart force and prone to an interface or an open failure. If, on the contrary, the load direction is in the direction in which the joint surfaces are compressed, that is, if, with the placement head 3 being halted at its lowered position so as to accommodate contraction of molten solder as it solidifies, a larger load is detected, then the placement head 3 is controlled to move up (S19), assuming that the placement head 3 has been lowered too much for the amount of contraction and that there is the risk that compressed solder may spread and adjacent solder bumps 1a may be short-circuited.

After the preset time period has passed in step S13, suction applied to the IC chip 1 from the suction nozzle 11 is released (S14) and the placement head 3 is moved up (S15) similarly to the previously described control method, so that the IC chip 1 is mounted on the substrate 4.

With these control steps, the distance between the IC chip 1 and the substrate 4, which varies due to the thermal expansion of the mounting tool 3 and the mounting stage 25, is made appropriate, whereby it is prevented that an interface or an open failure is created in the joint surfaces because of the pulling-apart force applied to the solder, and it is prevented that solder bulges sideways and adjacent solder bumps are short-circuited because of the compression force applied to the solder.

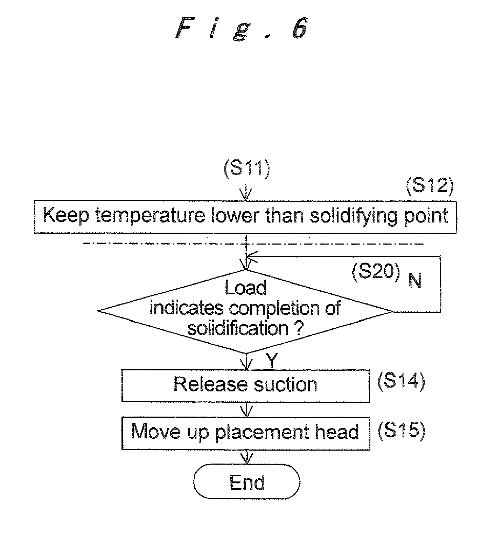

With the above control method, a preset waiting time is given for the molten solder to solidify, and depending on the ambient temperature, the waiting time may be wastefully spent even after the solder has solidified, causing the production time unnecessarily long. Therefore, the production time can be made shorter by determining whether the solder has solidified or not. The control method including the step of determining whether the solder has solidified is described with reference to Fig. 6. Fig. 6 shows a variation of control steps of the flowchart of Fig. 3 after the step S12 onward. The control steps up until the step S12 are the same as the previously described control method, and therefore the description and illustration of these steps are omitted.

Referring to Fig. 6, after the step (S12) where a temperature lower than the solidifying point of solder is maintained so as to let the molten solder to solidify, the solidified state of the solder is determined based on the load detected with the load cell 14 (520). As the solder solidifies, the temperature of the mounting tool 3a decreases, but the temperature of the mounting stage 25 decreases with a time lag, and the heat is conducted from the mounting stage 25 to the mounting tool 3a, causing thermal expansion in the mounting tool 3a again. When the solder has already solidified by this time, the load detected with the load cell 14 is increased. The solidified state of the solder is thus determined from the detected load; if a preset load is detected, it is determined that the bonding has completed and suction applied to the IC chip 1 from the suction nozzle 11 is released (S14) and the placement head 3 is moved up (S15), so that the IC chip 1 is mounted on the substrate 4.

in the mounting method and apparatus described above, it is desirable that the thermal expansion of the mounting tool 3a be as small as possible; in order to prevent heat conduction from the ceramic heater 12 to other parts, it is preferable to use a material with a small thermal expansion coefficient for the heat insulator 13 that is interposed between the ceramic heater 12 and the support shaft 17. The material conventionally used for the heat insulator 13 has a thermal expansion coefficient of about 8 x 10⁻⁶; in this embodiment, a material having a thermal expansion coefficient of about 1 x 10⁻⁶ is used for the heat insulator 13, so as to reduce thermal expansion of the entire mounting tool 3a.

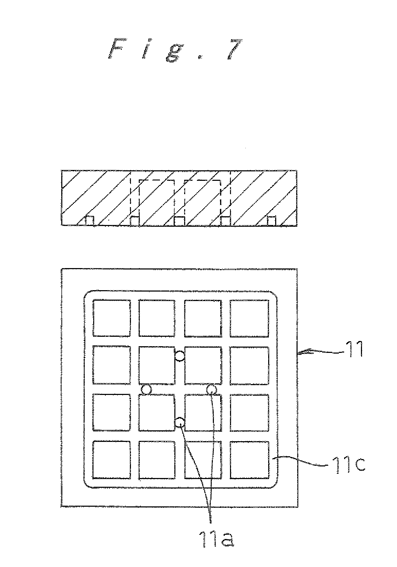

It is also desirable that the deformation in the IC chip 1 caused by the suction force from the suction nozzle 11 be as small as possible; one possibility is to employ a suction nozzle 11 which includes, in addition to the suction holes 11a, suction grooves 11c communicating with the suction holes 11a in the suction surface 11b of the nozzle as shown in Fig. 7. Thin IC chips 1 lose flatness more easily when vacuum is locally applied, and the larger the IC chips 1 are, the larger the deformation is. The suction grooves 11c in the suction surface 11b as shown in Fig. 7 cause the suction force to be applied uniformly and entirely to the IC chip 1, and therefore decrease vacuum-induced deformation of the IC chip 1. While the illustrated example is grid-like, the suction grooves 11c may freely be designed in other patterns such as a pattern that causes the suction force to be applied uniformly and entirely to the IC chip 1, or a pattern that causes the suction force to be concentrated on specific parts such as the periphery.

In the mounting control method described above, a preferable mode would be to perform all of the control steps, as shown in the flowchart of Fig. 3, of correcting deformation of the IC chip 1, correcting a change in the chip/substrate distance caused by heating and consequent thermal expansion, and correcting a change in the chip/substrate distance caused by contraction of molten solder as it solidifies. This is not a requirement, however, and one or more of these steps may be suitably selected depending on the required bonding precision and the type of IC chip 1.

### INDUSTRIAL APPLICABILITY

As described above, when mounting electronic components that can easily lose flatness such as IC chips that have become thinner in recent years on a substrate, deformation in the component is corrected and the component is precisely mounted on the substrate. Also, appropriate control is provided to deal with thermal expansion that occurs when heat is applied to melt solder, which enables bonding of a large number of protruded electrodes with substrate electrodes without bonding failure. Also, appropriate control is provided to deal with contraction that occurs as the thermally expanded parts cool down, which ensures that there will be no interface or open failure in fused solder and that there will be no short-circuiting across adjacent electrodes due to bulged solder, even if a large number of electrodes are arranged with a narrow pitch. Thus the present invention provides a method and apparatus for mounting components that enables IC chips that have become thinner and more highly integrated to be precisely mounted on a substrate.

## Claims

1. A component mounting method comprising the steps of:
holding an electronic component (1) formed with a plurality of protruded electrodes (1a) with a suction nozzle (11) set in a placement head (3) that is controlled to move up and down, while a substrate (4) formed with a plurality of substrate electrodes (4a) is held on a mounting stage (25); lowering the placement head so that the protruded electrodes make contact with the substrate electrodes; and applying heat to melt the protruded electrodes to bond both electrodes together to mount the electronic component on the substrate,
wherein the method including the steps of: detecting contact load when the placement head is lowered and the protruded electrodes make contact with the substrate electrodes; lowering the suction nozzle to a position where a preset contact load is detected, after which heat is applied to melt and fuse the protruded electrodes with the substrate electrodes; stopping heating to cool down and solidify the molten parts; and releasing suction from the suction nozzle and moving up the placement head.

2. A component mounting method comprising the steps of:
holding an electronic component (1) formed with a plurality of protruded electrodes (1a) with a suction nozzle (11) set in a placement head (3) that is controlled to move up and down, while a substrate (4) formed with a plurality of substrate electrodes (4a) is held on a mounting stage (25); lowering the placement head so that the protruded electrodes make contact with the substrate electrodes; and applying heat to melt the protruded electrodes to bond both electrodes together to mount the electronic component on the substrate,
wherein the method including the steps of: lowering the placement head so that the protruded electrodes make contact with the substrate electrodes; moving up the placement head by an amount that makes up for thermal expansion that occurs in the placement head and in the mounting stage when they heat up; applying heat to a preset temperature to melt and fuse the protruded electrodes with the substrate electrodes; stopping heating to cool down and solidify the molten parts; and releasing suction applied to the electronic component from the suction nozzle and moving up the placement head.

3. A component mounting method comprising the steps of:
holding an electronic component (1) formed with a plurality of protruded electrodes (1a) with a suction nozzle (11) set in a placement head (3) that is controlled to move up and down, while a substrate (4) formed with a plurality of substrate electrodes (4a) is held on a mounting stage (25); lowering the placement head so that the protruded electrodes make contact with the substrate electrodes; and applying heat to melt the protruded electrodes to bond both electrodes together to mount the electronic component on the substrate,
wherein the method including the steps of: lowering the placement head so that the protruded electrodes make contact with the substrate electrodes; applying heat to a preset temperature to melt and fuse the protruded electrodes with the substrate electrodes; stopping heating and moving down the placement head by an amount that makes up for contraction that occurs in the placement head and in the mounting stage when they cool down; and after the molten parts have solidified, releasing suction applied to the electronic component from the suction nozzle and moving up the placement head.

4. A component mounting method comprising the steps of:
holding an electronic component (1) formed with a plurality of protruded electrodes (1a) with a suction nozzle (11) set in a placement head (3) that is controlled to move up and down, while a substrate (4) formed with a plurality of substrate electrodes (4a) is held on a mounting stage (25); lowering the placement head so that the protruded electrodes make contact with the substrate electrodes; and applying heat to melt the protruded electrodes to bond both electrodes together to mount the electronic component on the substrate,
wherein the method including the steps of: detecting contact load when the placement head is lowered and the protruded electrodes make contact with the substrate electrodes; lowering the suction nozzle to a position where a preset contact load is detected; moving up the placement head by an amount that makes up for thermal expansion that occurs in the placement head and in the mounting stage when they heat up; applying heat to a preset temperature to melt and fuse the protruded electrodes with the substrate electrodes; stopping heating to cool down and solidify the molten parts; and after the molten parts have solidified, releasing suction applied to the electronic component from the suction nozzle and the placement head is moved up.

5. A component mounting method comprising the steps of:
holding an electronic component (1) formed with a plurality of protruded electrodes (1a) with a suction nozzle (11) set in a placement head (3) that is controlled to move up and down,
while a substrate (4) formed with a plurality of substrate electrodes (4a) is held on a mounting stage; lowering the placement head so that the protruded electrodes make contact with the substrate electrodes; and applying heat to melt the protruded electrodes to bond both electrodes together to mount the electronic component on the substrate,
wherein the method including the steps of: detecting contact load when the placement head is lowered and the protruded electrodes make contact with the substrate electrodes; lowering the suction nozzle to a position where a preset contact load is detected; applying heat to a preset temperature to melt and fuse the protruded electrodes with the substrate electrodes; stopping heating and moving down the placement head by an amount that makes up for contraction that occurs in the placement head and in the mounting stage when they cool down; and after the molten parts have solidified, releasing suction applied to the electronic component from the suction nozzle and moving up the placement head.

6. A component mounting method comprising the steps of:
holding an electronic component (1) formed with a plurality of protruded electrodes (1a) with a suction nozzle (11) set in a placement head (3) that is controlled to move up and down, while a substrate (4) formed with a plurality of substrate electrodes (4a) is held on a mounting stage (25); lowering the placement head so that the protruded electrodes make contact with the substrate electrodes; and applying heat to melt the protruded electrodes to bond both electrodes together to mount the electronic component on the substrate,
wherein the method including the steps of: detecting contact load when the placement head is lowered and the protruded electrodes make contact with the substrate electrodes; lowering the suction nozzle to a position where a preset contact load is detected; moving up the placement head by an amount that makes up for thermal expansion that occurs in the placement head and in the mounting stage when they heat up; applying heat to a preset temperature to melt and fuse the protruded electrodes with the substrate electrodes; stopping heating and moving down the placement head by an amount that makes up for contraction that occurs in the placement head and in the mounting stage when they cool down; and after the molten parts have solidified, releasing suction applied to the electronic component from the suction nozzle and moving up the placement head.

7. The component mounting method according to any one of claims 1 to 6, wherein a temperature that is lower than the solidifying point of solder is maintained for a preset period of time, and only after the molten parts have solidified, the suction applied to the electronic component (1) from the suction nozzle (11) is released.

8. The component mounting method according to any one of claims 1 to 6, wherein in the preset time period in which the temperature that is lower than the solidifying point of solder is maintained so as to solidify the molten parts, the direction in which load is applied to the electronic component (1) is detected to control the placement head (3) to move up or down depending on the detected load direction.

9. The component mounting method according to any one of claims 1 to 6, wherein after the preset time period in which the temperature that is lower than the solidifying point of solder is maintained so as to solidify the molten parts, suction applied to the electronic component (1) from the suction nozzle (11) is released when a preset load is detected that determines whether the solder has solidified.

10. A component mounting apparatus, wherein an electronic component (1) formed with a plurality of protruded electrodes (1a) is held with a suction nozzle (11) set in a placement head (3), while a substrate (4) formed with a plurality of substrate electrodes (4a) is held on a mounting stage (25); the placement head is controlled to move up and down and lowered so that the protruded electrodes make contact with the substrate electrodes; and heat is applied to melt the protruded electrodes to bond both electrodes together to mount the electronic component on the substrate,
wherein the apparatus comprising means for detecting contact load when the placement head is lowered and the protruded electrodes make contact with the substrate electrodes, and a control unit for controlling the up and down movement of the placement head so that the contact load detected by this contact load detecting means reaches a preset level.

11. A component mounting apparatus, wherein an electronic component (1) formed with a plurality of protruded electrodes (1a) is held with a suction nozzle (11) set in a placement head (3), while a substrate (4) formed with a plurality of substrate electrodes (4a) is held on a mounting stage (25); the placement head is controlled to move up and down and lowered so that the protruded electrodes make contact with the substrate electrodes; and heat is applied to melt the protruded electrodes to bond both electrodes together to mount the electronic component on the substrate,
wherein the apparatus comprising a control unit (6) for controlling the placement head in its lowered position to move up by an amount in accordance with thermal expansion that occurs in the placement head and in the mounting stage when they heat up, and for controlling the placement head to move down by an amount that makes up for contraction that occurs in the placement head and in the mounting stage when they cool down after heating is stopped.

12. A component mounting apparatus, wherein an electronic component (1) formed with a plurality of protruded electrodes (1a) is held with a suction nozzle (11) set in a placement head (3), while a substrate (4) formed with a plurality of substrate electrodes (4a) is held on a mounting stage (25); a the placement head is controlled to move up and down and lowered so that the protruded electrodes make contact with the substrate electrodes; and heat is applied to melt the protruded electrodes to bond both electrodes together to mount the electronic component on the substrate,
wherein the apparatus comprising: a detecting unit (14) for detecting contact load when the placement head is lowered and the protruded electrodes make contact with the substrate electrodes, and a control unit (6) for controlling the up and down movement of the placement head so that the contact load detected by this contact load detecting unit reaches a preset level, for controlling the placement head in its lowered position to move up by an amount in accordance with thermal expansion that occurs in the placement head and in the mounting stage when they heat up, and for controlling the placement head to move down by an amount that makes up for contraction that occurs in the placement head and in the mounting stage when they cool down after heating is stopped.

13. The component mounting apparatus according to claim 12, wherein a heat insulating member (13) having a thermal expansion coefficient of not more than 1 x 10⁻⁶ is provided between the placement head main body and a heating unit (12) that is interposed between the suction nozzle (11) and the placement head main body (3).

14. The component mounting apparatus according to claim 11 or 12, wherein a suction surface (11b) of the suction nozzle (11) on which the electronic component (1) is held includes suction grooves (11c) that communicate with suction holes (11a) and are arrayed with a preset density over a region corresponding to the area of the electronic component.
